# EUROPÄISCHE PATENTSCHRIFT

(11) **EP 3 376 246 B1**
(45) Veröffentlichungstag und Bekanntmachung des Hinweises auf die Patenterteilung: **26.04.2023**
(21) Anmeldenummer: 17160758.3
(22) Anmeldetag: 14.03.2017
(51) Int. Cl.: G01R 33/561, G01R 33/483, G01R 33/567

(54) **BESCHLEUNIGTES ERZEUGEN EINER SERIE VON MAGNETRESONANZBILDERN MIT SIMULTANER MAGNETRESONANZ-MEHRSCHICHTBILDGEBUNG**
ACCELERATED GENERATION OF A SERIES OF MAGNETIC RESONANCE IMAGES WITH SIMULTANEOUS MAGNETIC RESONANCE MULTI-LAYER IMAGING
PRODUCTION ACCÉLÉRÉE D'UNE SÉRIE D'IMAGES PAR RÉSONANCE MAGNÉTIQUE AU MOYEN DE L'IMAGERIE À RÉSONANCE MAGNÉTIQUE MULTICOUCHES

(43) Veröffentlichungstag der Anmeldung: 19.09.2018
(73) Patentinhaber: Siemens Healthcare GmbH, 91052 Erlangen (DE)
(72) Erfinder: Beck, Thomas, 91052 Erlangen (DE)

(56) Entgegenhaltungen:
- DE-A1-102015 207 591
- US-A1- 2015 115 958
- FEINBERG DAVID A ET AL: "Ultra-fast MRI of the human brain with simultaneous multi-slice imaging", JOURNAL OF MAGNETIC RESONANCE, ACADEMIC PRESS, ORLANDO, FL, US, Bd. 229, 13. Februar 2013 (2013-02-13), Seiten 90-100, XP028996791, ISSN: 1090-7807, DOI: 10.1016/J.JMR.2013.02.002
- MARKUS BARTH ET AL: "Simultaneous multislice (SMS) imaging techniques : SMS Imaging", MAGNETIC RESONANCE IN MEDICINE., Bd. 75, Nr. 1, 26. August 2015 (2015-08-26), Seiten 63-81, XP055408927, US ISSN: 0740-3194, DOI: 10.1002/mrm.25897
- Kawin Setsompop ET AL: "Blipped-controlled aliasing in parallel imaging for simultaneous multislice echo planar imaging with reduced g-factor penalty", Magnetic Resonance in Medicine, vol. 67, no. 5, 1 May 2012 (2012-05-01), pages 1210-1224, XP055027257, ISSN: 0740-3194, DOI: 10.1002/mrm.23097

## Beschreibung

Die Erfindung betrifft ein Magnetresonanzbildgebungsverfahren zur Erzeugung einer Mehrzahl von Bilddatensätzen eines Bildaufnahmebereichs eines Untersuchungsobjekts. Überdies betrifft die Erfindung eine Steuerungseinrichtung. Weiterhin betrifft die Erfindung ein Magnetresonanzbildgebungssystem.

In der Medizin werden mit modernen bildgebenden Verfahren häufig zwei- oder dreidimensionale Bilddaten bis hin zu Zeitserien von Bilddaten erzeugt, die zur Visualisierung eines abgebildeten Untersuchungsobjekts genutzt werden. Diese bildgebenden Verfahren werden aber auch für Anwendungen außerhalb der Medizin genutzt. Zu den genannten bildgebenden Verfahren gehört unter anderem auch die Magnetresonanzbildgebung, auch Magnetresonanztomographie genannt.

Bei dem Verfahren der Magnetresonanztomographie wird meist ein statisches Grundmagnetfeld B₀, das zur Anfangsausrichtung und Homogenisierung von zu untersuchenden magnetischen Dipolen dient, zur Ortsauflösung des bildgebenden Signals mit einem schnell geschalteten Magnetfeld, dem sogenannten Gradientenfeld, überlagert. Zur Bestimmung von Materialeigenschaften eines abzubildenden Untersuchungsobjekts wird die Dephasierung bzw. Relaxationszeit nach einer Auslenkung der Magnetisierung aus der Anfangsausrichtung ermittelt, sodass verschiedene materialtypische Relaxationsmechanismen bzw. Relaxationszeiten identifiziert werden können. Die Auslenkung erfolgt meist durch eine Anzahl von HF-Pulsen und die Ortsauflösung beruht dabei auf einer zeitlich festgelegten Manipulation der ausgelenkten Magnetisierung mit Hilfe des Gradientenfelds in einer sogenannten Messsequenz bzw. Ansteuersequenz, welche eine genaue zeitliche Abfolge von HF-Pulsen, der Änderung des Gradientenfeldes (durch Aussenden einer Schaltsequenz von Gradientenpulsen) sowie der Erfassung von Messwerten festlegt. Neben der Relaxation gibt es noch eine Reihe weiterer Mechanismen zur Kontrastbildung, wie zum Beispiel die Flussmessung und die Diffusionsbildgebung.

Typischerweise erfolgt eine Zuordnung zwischen gemessener Magnetisierung - aus der die erwähnten Materialeigenschaften abgeleitet werden können - und einer Ortskoordinate der gemessenen Magnetisierung im Ortsraum, in dem das Untersuchungsobjekt angeordnet ist, mit Hilfe eines Zwischenschritts. In diesem Zwischenschritt werden erfasste Magnetresonanz-Rohdaten an Auslesepunkten im sogenannten "k-Raum" angeordnet, wobei die Koordinaten des k-Raums als Funktion des Gradientenfeldes kodiert sind. Der Betrag der Magnetisierung (insbesondere der Quermagnetisierung, in einer Ebene quer zum vorbeschriebenen Grundmagnetfeld bestimmt) an einem bestimmten Ort des Untersuchungsobjekts kann aus den k-Raum-Daten mit Hilfe einer Fourier-Transformation ermittelt werden. Anders ausgedrückt, werden die k-Raum-Daten (Magnitude und Phase) benötigt, um eine Signalstärke des Signals und gegebenenfalls dessen Phase im Ortsraum zu berechnen.

Die Magnetresonanztomographie ist eine relativ langsam arbeitende Art eines bildgebenden Verfahrens, da die Daten entlang von Trajektorien, wie zum Beispiel Zeilen oder Spiralen, im Fourierraum bzw. im k-Raum sequentiell aufgenommen werden. Das Verfahren der Aufnahme von Bildern in zweidimensionalen Schichten ist im Vergleich zur Aufnahme in drei Dimensionen deutlich weniger fehleranfällig, weil die Zahl der Kodierungsschritte kleiner ist als bei einem dreidimensionalen Verfahren. Daher werden bei vielen Anwendungen Bildvolumen mit Stapeln von zweidimensionalen Schichten statt einer einzigen dreidimensionalen Aufnahme verwendet. Allerdings sind die Bildaufnahmezeiten aufgrund der langen Relaxationszeiten der Spins sehr lang, was beispielsweise für zu untersuchende Patienten eine Verringerung des Komforts bedeutet.

Bei einer anderen Abtastungsart werden selektiv angeregte Subvolumen, sogenannte "Slabs", mit Hilfe eines dreidimensionalen Abtastverfahrens ortskodiert.

Werden von einem Patienten direkt hintereinander mehrere Bildaufnahmen mit unterschiedlichen Sequenzen mit unterschiedlichen Kontrasten aufgenommen, so ist es auch hierbei besonders wichtig, dass die Mehrzahl der dabei aufgenommenen Bilder in deckungsgleichen Schichten über den gesamten Bildgebungszeitraum dargestellt werden können. Einzelne Messungen einer Studie werden zeitlich nacheinander ausgeführt und durch Funktionalität und Benutzerschnittstelle kann eine konsistente Schichtorientierung und Schichtanzahl sowie eine Konsistenz eventuell vorhandener zusätzliche Sättigungsbänder oder ähnlichem erreicht werden. Die einzelnen Messungen werden anschließend größtenteils unabhängig voneinander durchgeführt. Der Begriff Sequenz oder Bildgebungssequenz soll eine zur Bildgebung erzeugte und über Gradientenspulen und HF-Spulen ausgespielte Pulssequenz zur Erzeugung von MR-Signalen verstanden werden, auf deren Basis Rohdaten erzeugt und daraus Bilddaten rekonstruiert werden. Eine solche Pulssequenz wird zunächst als Ansteuersequenz erzeugt und über eine Steuereinrichtung in Form von den Steuerbefehlen der Ansteuersequenz entsprechenden Pulsen ausgespielt.

Um die Bildaufnahmen zu beschleunigen, bzw. um die benötigte Messdauer zur Akquisition eines einzelnen Bildvolumens zu beschleunigen, hat sich in den letzten Jahren eine schichtbasierte Beschleunigungstechnologie etabliert. Mit dieser unter den Bezeichnungen "Simultaneous Multi-Slice" (abgekürzt SMS oder SAMS), "Slice Acceleration" oder auch "Multiband" bekannten Technologie werden mehrere Schichten gleichzeitig angeregt und ausgelesen (z.B. Breuer et al. MRM 53:684 (2005), Souza et al. JCAT 12:1026 (1988), Larkman et al. JMRI 13:313 (2001), MRM = Magnetic Resonance in Medicine, JMRI = Journal of Magnetic Resonance Imaging, JCAT = Journal of Computer Assisted Tomography). Beispielsweise werden bei einem Beschleunigungsfaktor von 3 jeweils 3 Schichten gleichzeitig angeregt und ausgelesen. Hierdurch reduziert sich die benötigte Repetitionszeit TR (Repetitionszeit TR = Zeit, bis aufeinanderfolgende Pulsfolgen auf die gleiche Schicht angewandt werden) auf ein Drittel der benötigten Zeit. Entsprechend kann beispielsweise bei der funktionellen Bildgebung (fMRI, BOLD) oder bei der Diffusionsbildgebung mittels echoplanarer Aufnahme die erforderliche Zeit zur Akquisition eines Volumens auf ein Drittel der benötigten Zeit reduziert werden. In der Literatur wird als Vorteil dieser Methoden hauptsächlich die Reduktion der Messzeit beziehungsweise die Verbesserung der zeitlichen Abtastrate angegeben.

Auch bei der Abtastung von selektiv angeregten Subvolumen besteht die Möglichkeit, mit Hilfe einer "Multi-Slab"-Bildgebung simultan mehrere Subvolumen oder Teilvolumen abzutasten, um den Aufnahmevorgang zu beschleunigen. Eine solche Vorgehensweise kann als Zwischenstufe zwischen einer 2D-Mehrschicht-Bildgebung und einer vollständigen 3D-Bildgebung angesehen werden.

Um die gleichzeitig gemessenen Schichten bzw. Teilvolumen im Rahmen der Bildrekonstruktion wieder in einzelne Schichten zerlegen zu können, wird üblicherweise von Beginn jeder einzelnen Messung eine zusätzliche Kalibrierungsbildaufnahme (auch Referenzbildaufnahme genannt) durchgeführt. Die benötigte Zeit für die Referenzbildaufnahmen reduziert den mit der beschriebenen SMS-Technik erzielten Zeitgewinn wieder, so dass insbesondere für klinisch relevante, meist recht kurze Protokolle der Zeitgewinn wieder reduziert wird.

Im Falle einer Bewegung des Patienten geht bei den beschriebenen Bildgebungsverfahren die Konsistenz der gemessenen Daten verloren, was sich durch Bildartefakte in dem rekonstruierten Bild widerspiegelt. Aus diesem Grund ist es erstrebenswert, die Bewegung des Patienten zu kompensieren. Dies geschieht entweder retrospektiv (nach der Messung) oder prospektiv (bereits während der Messung).

Verfahren der prospektiven Bewegungskorrektur korrigieren die Bewegung des Patienten bereits während der Durchführung der Messung. Dies geschieht beispielsweise dadurch, dass das Sichtfeld (Field of View = FoV), welches den zu akquirierenden Ausschnitt der Anatomie darstellt, während der Messung derart nachgeführt wird, so dass sich die darin enthaltene Anatomie trotz Bewegung nicht ändert. Um dies zu erreichen, existieren eine Vielzahl von Verfahren. Beispielsweise werden externe Systeme, insbesondere Kameras, zur Überwachung der Position des Untersuchungsobjekts eingesetzt. Eine Überwachung kann auch mit Hilfe von für ein Magnetresonanztomographiegerät sichtbaren Markern realisiert werden. Bei der Überwachung können anstatt Markern auch charakteristische anatomische Strukturen beobachtet werden. Überdies werden auch zusätzliche bildbasierte Navigatoren eingesetzt, um eine Positionsänderung des Untersuchungsobjekts zu detektieren und das Sichtfeld entsprechend nachzuführen.

Bei der Anwendung von bildbasierten Navigatoren wird die bildgebende MR-Sequenz dazu verwendet, die Anatomie in Navigatorbildern zu zeitlich aufeinanderfolgenden Zeitpunkten darzustellen. Typischerweise zu Beginn der Messung wird ein Referenzvolumen gemessen und nachfolgende Navigatorbilder werden auf diesen Referenzzeitpunkt registriert. Die detektierte Bewegung wird dann an die MR-Pulssequenz zurückgeführt und das Sichtfeld bzw. der Bildbereich wird für nachfolgende Teilakquisitionen um diese Bewegung nachgeführt und damit die Bewegung bereits während der Messung kompensiert.

Ein Problem bei der Bewegungskorrektur mit Hilfe von Navigatoren besteht darin, dass die Aufnahme des Navigatorbildes und die Akquisition des MR-Signals zur Bildgebung leicht zeitversetzt stattfinden. Selbst für den Fall, dass die erfolgte Bewegung des Navigators exakt detektiert und von der Sequenz kompensiert werden kann, verbleiben resultierende Artefakte in den MR-Daten, denn der Bewegungsanteil zwischen dem Zeitpunkt der Akquisition des Navigators und dem Zeitpunkt der Akquisition des gewünschten MR-Bildgebungssignals wird nicht erfasst und kann daher auch nicht kompensiert werden.

Die zusätzliche Aufnahme der Navigatoren bedeutet außerdem einen zusätzlichen Zeitaufwand, wodurch die Bildgebungssequenz nicht optimal effizient ausgeführt werden kann.

In DE 10 2015 207 591 A1 erfolgt eine Magnetresonanz-Referenzbildaufnahme zu einem ersten Zeitpunkt und eine Magnetresonanzbildaufnahme zu einem zweiten Zeitpunkt. Anhand von ermittelten Verschiebungen zwischen den genannten Bildaufnahmen wird eine Bewegungskorrektur der Magnetresonanzbildaufnahme durchgeführt.

In Kawin Setsompop et al: "Blipped-controlled aliasing in parallel imaging for simultaneous multislice echo planar imaging with reduced g-factor penalty", Magnetic Resonance in Medicine, Bd. 67, Nr. 5, 1. Mai 2012 (2012-05-01), Seiten 1210-1224, XP055027257, ISSN: 0740-3194, DOI: 10.1002/- mrm.23097 wird ein Magnetresonanz-Mehrschichtbildgebungsverfahren beschrieben, bei dem eine Technik der simultanen Mehrschichtmessung angewendet wird.

Es ist eine Aufgabe der vorliegenden Erfindung, ein Verfahren zur Ansteuerung eines Magnetresonanzbildgebungssystems anzugeben, mit dem eine Serie von Bildaufnahmen mit unterschiedlichen Sequenzprotokollen in kürzerer Zeit beziehungsweise mit verbesserter Konsistenz bei einer gleichzeitigen Wahrung der Bildqualität durchgeführt werden kann.

Diese Aufgabe wird durch ein Magnetresonanzbildgebungsverfahren gemäß Patentanspruch 1, durch eine Steuerungseinrichtung gemäß Patentanspruch 10 und durch ein Magnetresonanzbildgebungssystem gemäß Patentanspruch 11 gelöst.

Bei dem erfindungsgemäßen Magnetresonanzbildgebungsverfahren zur Erzeugung einer Mehrzahl von Bilddatensätzen eines Bildaufnahmebereichs eines Untersuchungsobjekts wird mindestens ein Satz von Referenz-Magnetresonanzrohdaten von dem Bildaufnahmebereich erfasst. Ein solcher Satz von Referenz-Magnetresonanzrohdaten dient dazu, eine Mehrzahl von Faltungskernen zu berechnen, mit denen nach einer simultanen MR-Bildaufnahme von mehreren Schichten die gemessene Information bezüglich mehrerer Schichten in die einzelnen Schichten zugeordnete Bildinformation zerlegt werden kann. Die Zerlegung in einzelne Schichten kann sowohl im k-Raum als auch im Bilddatenraum erfolgen, wobei allerdings eine Zerlegung von simultan aufgenommenen Schichten in einzelne Schichten im k-Raum bevorzugt angewendet wird.

Es wird eine Mehrzahl von Magnetresonanz-Rohdatensätzen zeitlich nacheinander erfasst, wobei zumindest eine Mehrzahl der Magnetresonanz-Rohdatensätze mit einer SMS-Bildaufnahmesequenz aufgenommen werden. Wie bereits erwähnt, soll eine solche SMS-Bildaufnahmesequenz eine MR-Bildaufnahmesequenz umfassen, bei der mehrere Schichten des Untersuchungsbereichs simultan aufgenommen werden.

Unter den Begriff SMS-Bildaufnahmesequenz soll auch die bereits erwähnte Abtastungsart fallen, bei der anstatt mehrerer Schichten mehrere selektiv angeregte Subvolumen, sogenannte "Slabs", mit Hilfe eines dreidimensionalen Abtastverfahrens ortskodiert und simultan ausgelesen werden.

Weiterhin erfolgt eine Rekonstruktion einer Mehrzahl von Bilddatensätzen auf Basis der erfassten Magnetresonanz-Rohdatensätze, wobei eine Mehrzahl von SMS-Bilddatensätzen jeweils auf Basis eines der mit einer SMS-Bildaufnahmesequenz aufgenommenen Magnetresonanz-Rohdatensätze und jeweils auf Basis ein und desselben Satzes von Referenz-Magnetresonanzrohdaten rekonstruiert werden.

Magnetresonanz-Rohdatensätze zur Rekonstruktion von Navigatorbilddatensätzen, die z.B. zur Bewegungskorrektur benutzt werden können, werden zwischen der Aufnahme von Magnetresonanz-Rohdatensätzen, welche zur Rekonstruktion einer Bilddarstellung des Bildaufnahmebereichs (FoV) genutzt werden, erfasst.

Vorteilhaft werden auf diese Weise über den gesamten Bildaufnahmevorgang verteilt Bewegungskorrekturen durchgeführt, so dass die Artefakte aufgrund einer Bewegung des abzubildenden Bereichs fein aufgelöst reduziert werden können.

Vorteilhaft werden bei dem erfindungsgemäßen Magnetresonanzbildgebungsverfahren zumindest ein Teil der aufeinander folgenden MR-Aufnahmen, seien es Bildaufnahmen und/oder Navigator-Aufnahmen, mit einer beschleunigten Aufnahmesequenz, einer sogenannten SMS-Bildaufnahmesequenz aufgenommen. Besonders vorteilhaft wird nun eine einzige Aufnahme von Referenzrohdaten als Referenzdaten für eine Mehrzahl von beschleunigten MR-Aufnahmen genutzt, so dass nicht für jede dieser Aufnahmen erneut eine solche, oft zeitaufwändige Referenz-Aufnahme durchgeführt werden muss. Die Aufnahme der Referenzdaten erfolgt nämlich unbeschleunigt, so dass sie besonders viel Zeit in Anspruch nimmt. Indem die Anzahl der aufzunehmenden Referenzdatensätze durch Wiederverwendung reduziert wird, wird der gesamte Bildaufnahmeprozess mithin besonders stark beschleunigt. Somit erfolgt das gesamte Magnetresonanzbildgebungsverfahren deutlich schneller als bei einer herkömmlichen Vorgehensweise. Ein zusätzlicher Zeitgewinn ergibt sich dadurch, dass die Kernel zur Trennung der simultan aufgenommenen Schichten für einen Referenzdatensatz nur einmal berechnet werden müssen. Da die Berechnung dieser Kernel einen signifikanten Anteil zur Rekonstruktionszeit beiträgt, kann durch eine Wiederverwendung eines Referenzdatensatzes besonders viel Zeit gewonnen werden.

Bei der Anwendung vieler klinischer Protokolle werden mehrere Bildkontraste mit unterschiedlichen Sequenzen mit identischen Schichtpositionen nacheinander angewendet. Für mehrere SMSbeschleunigten Sequenzen können in diesem Fall jeweils dieselben Referenzdaten wiederverwendet werden.

Die Verwendung eines gemeinsamen Referenzdatensatzes kann immer dann erfolgen, wenn sich das Untersuchungsobjekt zwischen der Anwendung unterschiedlicher Aufnahmesequenzen nicht zu stark bewegt, so dass sich die Orientierung im Raum zumindest nur wenig ändert und eine identische Anatomie abgebildet wird. Vorteilhaft ist auch eine identische Schichtanzahl, wobei jedoch auch bei unterschiedlicher Schichtzahl bei aufeinander folgenden Bildaufnahmen mit Hilfe einer Interpolation der Referenzdaten eine Anpassung auf die korrekte Anzahl der jeweiligen aufgenommenen Schichten erfolgen kann, wie später noch erläutert wird.

Die erfindungsgemäße Steuerungseinrichtung weist eine Ansteuerungseinheit zur Ansteuerung einer Scaneinheit eines Magnetresonanzbildgebungssystems mit einer Bildaufnahmesequenz zur Erzeugung einer Mehrzahl von Bilddatensätzen eines Bildaufnahmebereichs eines Untersuchungsobjekts. Teil der erfindungsgemäßen Steuerungseinrichtung ist auch eine Referenzsequenz-Erzeugungseinheit zum Erzeugen einer Referenz-Bildaufnahme-Teilsequenz zum Erfassen mindestens eines Satzes von Referenz-Magnetresonanzrohdaten von dem Bildaufnahmebereich. Teil der erfindungsgemäßen Steuerungseinrichtung ist auch eine Bildsequenz-Erzeugungseinheit zum Erzeugen einer Mehrzahl von Bildaufnahme-Teilsequenzen zum zeitlich nacheinander Erfassen von Magnetresonanz-Rohdatensätzen, wobei zumindest eine Mehrzahl der Bildaufnahme-Teilsequenzen eine SMS-Bildaufnahmesequenz umfassen. Zudem umfasst die erfindungsgemäße Steuereinrichtung auch eine Rekonstruktionseinheit zum Rekonstruieren einer Mehrzahl von Bilddatensätzen auf Basis der erfassten Magnetresonanz-Rohdatensätze, wobei eine Mehrzahl von SMS-Bilddatensätzen jeweils auf Basis eines der mit einer SMS-Bildaufnahmesequenz aufgenommenen Magnetresonanz-Rohdatensätze und jeweils auf Basis ein und desselben Satzes von Referenz-Magnetresonanzrohdaten rekonstruiert werden. Der Satz von Referenz-Magnetresonanzrohdaten dient dazu, nach einer simultanen MR-Bildaufnahme von mehreren Schichten die gemessene Information bezüglich mehrerer Schichten in den einzelnen Schichten zugeordnete Bildinformation zu zerlegen.

Das erfindungsgemäße Magnetresonanzbildgebungssystem umfasst eine Scaneinheit und eine erfindungsgemäße Steuerungseinrichtung zur Ansteuerung der Scaneinheit.

Die wesentlichen Komponenten der erfindungsgemäßen Steuerungseinrichtung können zum überwiegenden Teil in Form von Softwarekomponenten ausgebildet sein. Dies betrifft insbesondere die Ansteuerungseinheit, die Referenzsequenz-Erzeugungseinheit, die Bildsequenz-Erzeugungseinheit und die Rekonstruktionseinheit. Grundsätzlich können diese Komponenten aber auch zum Teil, insbesondere wenn es um besonders schnelle Berechnungen geht, in Form von softwareunterstützter Hardware, beispielsweise FPGAs oder dergleichen, realisiert sein. Ebenso können die benötigten Schnittstellen, beispielsweise wenn es nur um eine Übernahme von Daten aus anderen Softwarekomponenten geht, als Softwareschnittstellen ausgebildet sein. Sie können aber auch als hardwaremäßig aufgebaute Schnittstellen ausgebildet sein, die durch geeignete Software angesteuert werden.

Eine weitgehend softwaremäßige Realisierung hat den Vorteil, dass auch schon bisher verwendete Steuereinrichtungen auf einfache Weise durch ein Software-Update nachgerüstet werden können, um auf die erfindungsgemäße Weise zu arbeiten. Insofern wird die Aufgabe auch durch ein entsprechendes Computerprogrammprodukt mit einem Computerprogramm gelöst, welches direkt in eine Speichereinrichtung einer Steuereinrichtung eines Magnetresonanztomographiesystems ladbar ist, mit Programmabschnitten, um alle Schritte des erfindungsgemäßen Verfahrens auszuführen, wenn das Programm in der Steuereinrichtung ausgeführt wird. Ein solches Computerprogrammprodukt kann neben dem Computerprogramm gegebenenfalls zusätzliche Bestandteile wie z. B. eine Dokumentation und/oder zusätzliche Komponenten auch Hardware-Komponenten, wie z.B. Hardware-Schlüssel (Dongles etc.) zur Nutzung der Software, umfassen.

Zum Transport zur Steuereinrichtung und/oder zur Speicherung an oder in der Steuereinrichtung kann ein computerlesbares Medium, beispielsweise ein Memorystick, eine Festplatte oder ein sonstiger transportabler oder fest eingebauter Datenträger dienen, auf welchem die von einer Rechnereinheit der Steuereinrichtung einlesbaren und ausführbaren Programmabschnitte des Computerprogramms gespeichert sind. Die Rechnereinheit kann z.B. hierzu einen oder mehrere zusammenarbeitende Mikroprozessoren oder dergleichen aufweisen.

Die abhängigen Ansprüche sowie die nachfolgende Beschreibung enthalten jeweils besonders vorteilhafte Ausgestaltungen und Weiterbildungen der Erfindung. Dabei können insbesondere die Ansprüche einer Anspruchskategorie auch analog zu den abhängigen Ansprüchen einer anderen Anspruchskategorie und deren Beschreibungsteilen weitergebildet sein. Zudem können im Rahmen der Erfindung die verschiedenen Merkmale unterschiedlicher Ausführungsbeispiele und Ansprüche auch zu neuen Ausführungsbeispielen kombiniert werden.

In einer bevorzugten Ausgestaltung des erfindungsgemäßen Magnetresonanzbildgebungsverfahrens werden die Mehrzahl von Magnetresonanz-Rohdatensätzen mit unterschiedlich gewählten Bildgebungsparametern zeitlich nacheinander erfasst. D.h., die aufeinanderfolgenden einzelnen Bildgebungssequenzen zur Aufnahme von unterschiedlichen Magnetresonanz-Rohdatensätzen unterscheiden sich hinsichtlich eines oder mehrerer Bildgebungsparameter. Solche Bildgebungsparameter umfassen alle bei einer Bildgebungssequenz bzw. einem der Bildgebungssequenz zugrundeliegenden Protokoll einstellbaren Parameter. Besonders bevorzugt umfassen Bildgebungsparameter Parameter einer Bildgebungssequenz, welche die Bildqualität, insbesondere den Kontrast, den Bildaufnahmebereich und dessen Position oder die Bildgröße beeinflussen.

In einer besonders praktikablen Variante des erfindungsgemäßen Magnetresonanzbildgebungsverfahrens wird genau ein Satz von Referenz-Magnetresonanzrohdaten von dem Bildaufnahmebereich erfasst und es werden alle SMS-Bilddatensätze jeweils auf Basis eines der mit einer SMS-Bildaufnahmesequenz aufgenommenen Magnetresonanz-Rohdatensätze und jeweils auf Basis des gemeinsamen Satzes von Referenz-Magnetresonanzrohdaten rekonstruiert. Vorteilhaft wird bei dieser Variante der Aufwand für die Aufnahme der Referenzrohdaten minimiert, so dass das Beschleunigungspotential der Anwendung einer SMS-Bildaufnahmesequenz optimal genutzt werden kann.

Erfindungsgemäß ist es vorgesehen, dass die Bilddatensätze zur Bilddarstellung des Bildaufnahmebereichs verwendete Bilddatensätze und Navigatorbilddatensätze umfassen. Die Navigatorbilddatensätze können vorteilhaft zur Bewegungskorrektur der zur Bilddarstellung verwendeten Bilddatensätze genutzt werden. Insbesondere bei einer größeren Anzahl von nacheinander aufgenommenen Bilddatensätzen, welche beispielsweise mit unterschiedlichen Bildgebungsparametern bzw. unterschiedlichen Kontrasten aufgenommen werden, ist es sinnvoll, eventuell auftretende Bewegungen des Untersuchungsobjekts mit Hilfe von Navigatordaten zu korrigieren, um Bewegungsartefakte bei der Bilddarstellung zu reduzieren.

Bei der Anwendung von Navigatoren kann auch eine Koregistrierung der sequentiell durchgeführten Bildaufnahmen zur Kompensation der Patientenbewegung durchgeführt werden. Hieraus ergeben sich insbesondere bei der Anwendung von Bildgebungssequenzen mit unterschiedlichen Bildgebungsparametern für die Überlagerung der unterschiedlichen Bildkontraste entscheidende Vorteile, da bereits prospektiv währen der Bildaufnahme ein Großteil der Patientenbewegung kompensiert werden kann. Eine retrospektive Interpolation bzw. Koregistrierung der Bilddaten wird dadurch reduziert, wodurch unter anderem Interpolationsartefakte minimiert werden können.

Alternativ oder zusätzlich kann die Bewegungskorrektur auch durch Navigatorinformationen erfolgen, die durch die Akquisition mit Hilfe einer externen Kamera und/oder mit Hilfe von Markern gewonnen wurden. Vorteilhaft müssen bei dieser Variante keine zusätzlichen MR-Aufnahmesequenzen in den Bildgebungsprozess aufgenommen werden, wodurch eine Beschleunigung des gesamten Bildaufnahmevorgangs erreicht werden kann.

In einer besonders vorteilhaft anzuwendenden Variante des erfindungsgemäßen Magnetresonanzbildgebungsverfahrens wird ein Magnetresonanz-Rohdatensatz zur Rekonstruktion eines Referenz-Navigatorbilddatensatzes erfasst, wobei der Referenz-Navigatorbilddatensatz als Bezugsbild für eine Bewegungskorrektur auf Basis der Navigatorbilddatensätze verwendet wird. Bei dieser besonders vorteilhaften Ausgestaltung wird zunächst vorab ein Bezugsbild als Vergleichsgröße für die später aufgenommenen Navigatorbilder erfasst. Durch Vergleich der Navigatorbilder mit dem Bezugsbild kann dann im Laufe des Bildgebungsvorgangs oder auch nachträglich eine Bewegung des Aufnahmebereichs detektiert werden und gegebenenfalls kompensiert bzw. korrigiert werden.

Der Vergleich zwischen dem Bewegungsreferenzbild und den Navigatorbildern kann sowohl im Bildraum, auch Bilddatenraum genannt, als auch im k-Raum erfolgen. Die Bestimmung der durch den Vergleich zu ermittelnden Bewegungsparameter (meist 6 rigide Freiheitsgrade (3 translatorische und 3 rotatorische)) können also in beiden Räumen durchgeführt werden. Eine Rotation im Bildraum entspricht einer identischen Rotation im k-Raum und eine Translation im Bildraum entspricht einer Multiplikation mit einer Phasenrampe im k-Raum. Eine besonders bevorzugte Implementierung basiert auf einer Detektion der Bewegungsparameter im Bildraum.

Bevorzugt wird mindestens ein Magnetresonanz-Rohdatensatz zur Rekonstruktion von Navigatorbilddatensätzen während mindestens einer kurzen Unterbrechung einer Aufnahme von Magnetresonanz-Rohdatensätzen, welche zur Rekonstruktion einer Bilddarstellung des Bildaufnahmebereichs genutzt werden, erfasst. Die Unterbrechung kann zum Beispiel zwischen Aufnahmen mit unterschiedlichen Bildaufnahmeparametern erfolgen. Die Unterbrechung kann auch innerhalb einer Bildaufnahme mit denselben Bildaufnahmeparametern erfolgen, falls einzelne Bildaufnahmen besonders viel Zeit benötigen oder das Untersuchungsobjekt bzw. der Untersuchungsbereich stark in Bewegung ist.

In dem erfindungsgemäßen Magnetresonanzbildgebungsverfahrens wird eine Mehrzahl der Magnetresonanz-Rohdatensätze, welche zur Rekonstruktion einer Bilddarstellung des Bildaufnahmebereichs genutzt werden, mit einer SMS-Bildaufnahmesequenz erfasst und es werden SMS-Bilddatensätze jeweils auf einem der Mehrzahl der Magnetresonanz-Rohdatensätze und jeweils auf Basis ein und desselben Satzes von Referenz-Magnetresonanzrohdaten rekonstruiert. Durch den Einsatz der beschleunigten Bildgebungsverfahren für die üblicherweise hochaufgelösten und zeitraubenden Bildgebungsprozesse kann der gesamte Bildaufnahmeprozess besonders stark beschleunigt werden. Da für die Zerlegung der gemessenen Information bezüglich mehrerer Schichten in die einzelnen Schichten zugeordnete Bildinformation ein- und derselbe Referenzdatensatz verwendet wird, kann der Aufwand für die Gewinnung von Referenzdaten stark reduziert werden und so der gesamte Prozess besonders stark beschleunigt werden.

In einer bevorzugten Variante des erfindungsgemäßen Bildgebungsverfahrens wird zumindest eine Mehrzahl der Magnetresonanz-Rohdatensätze zur Rekonstruktion von Navigatorbilddatensätzen mit einer SMS-Bildaufnahmesequenz erfasst. Dabei werden SMS-Navigatorbilddatensätze jeweils auf Basis eines der Mehrzahl der Magnetresonanz-Rohdatensätze und jeweils auf Basis ein und desselben Satzes von Referenz-Magnetresonanzrohdaten rekonstruiert. Indem auch die Navigatorbilddaten beschleunigt erzeugt werden, kann eine weitere Beschleunigung des Bildgebungsprozesses erlangt werden.

Die Beschleunigung des Bildgebungsprozesses ist dann besonders ausgeprägt, wenn zumindest ein Teil der SMS-Navigatorbilddatensätze und ein Teil der SMS-Bilddatensätze auf Basis eines gemeinsamen Satzes von Referenz-Magnetresonanzrohdaten rekonstruiert werden. Denn dann muss nur ein einziger Referenzdatensatz sowohl für die beschleunigte Durchführung der eigentlichen Bildaufnahme als auch für die Aufnahme der Navigatordaten aufgenommen werden, wodurch der gesamte Bildaufnahmeprozess weiter beschleunigt wird.

Besonders bevorzugt ist es, wenn alle der SMS-Navigatorbilddatensätze und alle SMS-Bilddatensätze auf Basis eines gemeinsamen Satzes von Referenz-Magnetresonanzrohdaten rekonstruiert werden. Denn dann ist die Zeitersparnis aufgrund des gemeinsam verwendeten Satzes von Referenz-Magnetresonanzrohdaten besonders ausgeprägt.

Die bei den nacheinander erfolgenden Bildaufnahmen angewendeten Bildaufnahmesequenzen können besonders vorteilhaft unterschiedliche Kontraste haben, um zusätzliche Information von einem Untersuchungsbereich zu gewinnen. Hierzu können unterschiedlich gewählte Bildgebungsparameter angewendet werden. Die unterschiedlichen Bildgebungsparameter können mindestens eine der folgenden Größen umfassen:
- den Amplitudenwert,
- den Amplitudenverlauf,
- den Startzeitpunkt und die Dauer,
- die Anzahl der Anregungspulse,
- den Sequenztyp,
- die Schichtdicke,
- die Schichtorientierung.

Der Amplitudenwert, der Amplitudenverlauf und der Startzeitpunkt und die Dauer beziehen sich bevorzugt auf die bei einer Bildaufnahmesequenz ausgespielten Gradientenpulse.

Bei bekannter Patientenbewegung zwischen aufeinanderfolgenden Bildaufnahmevorgängen kann zum Beispiel eine Kompensation der Änderung der Schichtorientierung gemäß der US-Patentanmeldung mit der Aktennummer US 15 351 471 erfolgen.

Ändert sich die Schichtzahl oder die Schichtorientierung zwischen einzelnen Bildaufnahmen, so kann eine Wiederverwendung der Referenzdaten dadurch erleichtert werden, dass anfangs eine hochaufgelöste 3D-Bildaufnahme als Referenzaufnahme erfolgt. Im Rahmen der Berechnung der Schichttrennungs-Kernel wird dann anschließend aus der 3D-Referenzaufnahme auf die korrekte Schichtzahl und Schichtorientierung interpoliert. Ein Verfahren zur Interpolation der Referenzdaten bei der Kernel-Neuberechnung während einer einzelnen Messung ist zum Beispiel in der deutschen Patentanmeldung mit der Aktennummer 10 2017 201 477 beschrieben. Auf diese Weise können auch Messprotokolle mit voneinander abweichenden Bildgebungsparametern mit nur einer einzigen Referenzbildaufnahme zur Anwendung gebracht werden.

Die erwähnten Navigatorbilddaten können beispielsweise zur Echtzeit-Positionskorrektur des aktuellen Bildaufnahmebereichs des Untersuchungsobjekts, auch prospektive Bewegungskorrektur genannt, verwendet werden. D.h., die Navigatorbilddaten werden als Information bezüglich einer Bewegung des Aufnahmebereichs genutzt. Diese Information wird auf die Orientierung der zukünftig zu messenden Bildanteile angewandt, so dass eine prospektive Bewegungskompensation erreicht wird. Es kann also der Aufnahmebereich während der Bildaufnahme einer Bewegung entsprechend nachgeführt werden, so dass Verschiebungen und Artefakte innerhalb einer einzelnen Bildaufnahme sowie zwischen zeitlich nacheinander aufgenommenen Bilddaten reduziert werden können.

Außerdem können die erfassten Navigatorbilddaten alternativ oder zusätzlich auch zur retrospektiven Positionskorrektur von aufgenommenen Bilddaten verwendet werden. Dabei werden die simultan erfassten Navigatorbilddaten dazu genutzt, die zeitgleich erfassten Bilddaten aus dem Bildvolumen hinsichtlich Artefakten aufgrund von Bewegungen des aufzunehmenden Bildvolumens zu korrigieren. Bei ergänzender Anwendung einer retrospektiven Korrektur kann die Qualität der Bildaufnahmen weiter verbessert werden.

In einer bevorzugten Ausgestaltung des erfindungsgemäßen Magnetresonanzbildgebungsverfahrens kann die Anzahl der Schichten bei der Aufnahme der Navigatordaten kleiner als die Anzahl der Schichten bei der eigentlichen Bildaufnahme sein. Zusätzlich kann die Aufnahme der Navigatordaten mit einem höheren Beschleunigungsfaktor erfolgen. Beide Maßnahmen führen dazu, dass der Untersuchungsbereich bei der Aufnahme der Navigatordaten mit einer höheren Geschwindigkeit bzw. häufiger abgetastet wird als bei der eigentlichen Bildaufnahme. Vorteilhaft kann auf diese Weise der Zeitaufwand bei der Aufnahme der Navigator-Rohdaten reduziert werden.

Alternativ kann der Untersuchungsbereich bei der Aufnahme der Navigatordaten auch höher aufgelöst als bei der eigentlichen Bildaufnahme erfasst werden, wenn zum Beispiel eine robuste dreidimensionale Bewegungsdetektion für ein Bildgebungsvolumen erforderlich ist, das aus einer sehr geringen Anzahl von Schichten besteht.

Die Erfindung wird im Folgenden unter Hinweis auf die beigefügten Figuren anhand von Ausführungsbeispielen noch einmal näher erläutert. Es zeigen:
FIG 1 die Berechnung von Faltungsmatrizen und Faltungskernen im Rahmen einer Referenzmessung,
FIG 2 die Anwendung der Faltungskerne zur Trennung zeitgleich gemessener k-Raum-Rohdaten,
FIG 3 ein Flussdiagramm, welches ein Magnetresonanzbildgebungsverfahren gemäß einem Ausführungsbeispiel der Erfindung veranschaulicht,
FIG 4 ein Flussdiagramm, welches den Schritt 3.III des in FIG 3 gezeigten Verfahrens im Detail zeigt,
FIG 5 ein Magnetresonanzbildgebungssystem gemäß einem Ausführungsbeispiel der Erfindung.

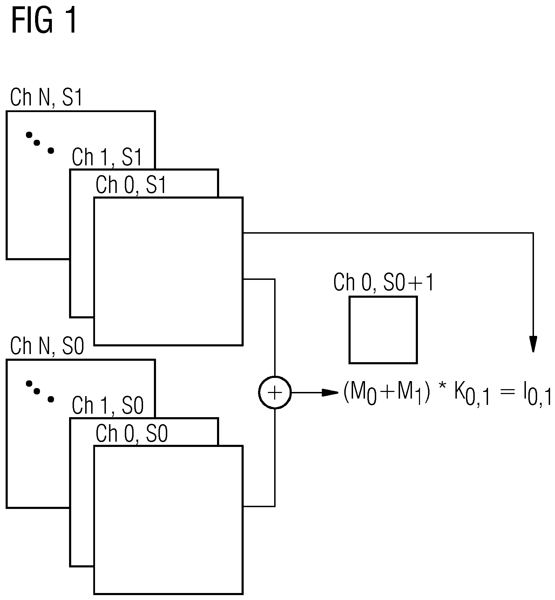

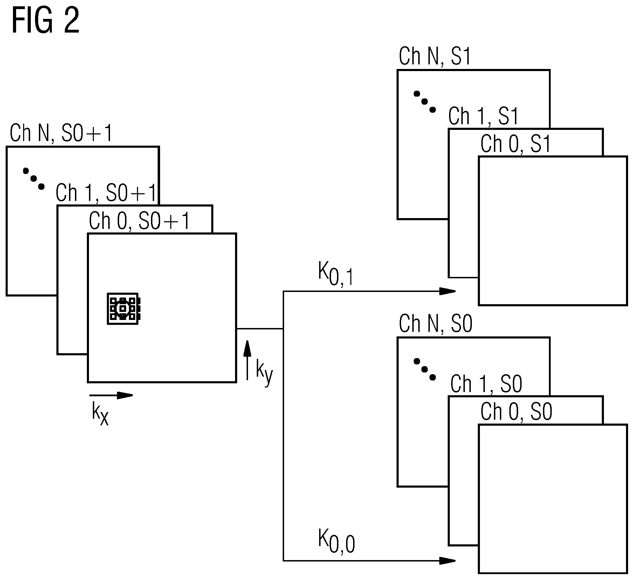

FIG 1 und FIG 2 illustrieren schematisch die mathematische Vorgehensweise bei einer simultanen Mehrschicht-Bildaufnahme mit Hilfe eines Magnetresonanzbildgebungsverfahrens. Hierdurch wird bei 2D-Messungen ermöglicht, die erforderliche Anzahl der sequentiellen Schichtmessungen mit dem Faktor der SMS-Beschleunigung zu reduzieren. Dabei sind typische Beschleunigungswerte im Bereich von 2 bis 6, abhängig von der Bildgebungssequenz und dem gemessenen Körperbereich, möglich. Um die gleichzeitig gemessenen Schichten im Rahmen der Rekonstruktion wieder in einzelne Schichten zerlegen zu können, wird üblicherweise vor Beginn der Messung eine zusätzliche Referenzaufnahme durchgeführt.

Die Trennung gleichzeitig gemessener Schichten kann im Einzelnen zum Beispiel wie von Stäb et al. MRM 65:157 (2011) vorgeschlagen durchgeführt werden. Das vorgeschlagene Verfahren beinhaltet, die von Grisworld et al. MRM (2002) beschriebene GRAPPA-Technik zur Trennung gleichzeitig angeregter Schichten anzuwenden, welche mit der CAIPIRINHA-Technik von Breuer et al. MRM (2005) gegeneinander verschoben sind. Hierzu wird im Rahmen eines Referenzscans, auch Kalibrierungsscan genannt, (vor Durchführung der bildgebenden Pulssequenz) das darzustellende Volumen gemessen. Dabei wird zum Beispiel ein vollständiges Volumen mit identischen Protokollparametern ohne Anwendung der SMS-Beschleunigung gemessen. Aus diesen Referenzdaten wird künstlich das Signal erzeugt, welches bei gleichzeitiger Anregung mehrerer Schichten zu erwarten wäre.

Die Protokollparameter des Referenzscans müssen allerdings nicht identisch mit den anschließend eingesetzten Protokollparametern sein. Ganz im Gegenteil können geeignete Sequenzen gewählt werden, die sich schnell akquirieren lassen und vorteilhafte Eigenschaften aufweisen (z.B. robust gegen Bewegung sind). Diese Vorgehensweise wird in Bhat et al., ISMRM 22 (2014) beschrieben (ISMRM = International Society for Magnetic Resonance in Medicine).

In FIG 1 bezeichnet Chn, Si gemessene Frequenzdaten des Spulenelementes n (n = 0 bis N, n ist eine natürlich Zahl) aus der Schicht Si (in FIG 1 ist i = 0) der sequentiellen Messung und Chn, Sj die gemessenen Frequenzdaten des Spulenelementes Chn aus der Schicht j (in FIG 1 ist j = 1) der sequentiellen Messung. Die Bildinformationen aus den Schichten i, j werden in einer Faltungsmatrix (Mᵢ+Mⱼ) (in FIG 1 ist als Beispiel die Faltungsmatrix (M₀+M₁) gezeigt) kombiniert, welche die gleichzeitig gemessenen Daten repräsentiert. Dabei wird für jede zu trennende Schicht j ein Faltungskern K_{n,j} bestimmt, der in der Lage ist, die Bildinformation I_{n,j} der Schicht j aus der Faltungsmatrix (Mᵢ+Mⱼ) zu extrahieren. Hierbei steht n für die n-te Spule CHn.

Im Rahmen der Bildakquisition durch die SMS-beschleunigte MR-Sequenz werden die so bestimmten Faltungskerne eingesetzt, um die gleichzeitig mit mehreren Spulen gemessene Information bezüglich mehrerer Schichten in die einzelnen Schichten und Spulen zugeordnete Bildinformation zerlegen. Dieser Vorgang ist in FIG 2 veranschaulicht. Beispielsweise ist in FIG 2 ein Faltungskern K_{0,1} gezeigt, mit dem die gemischten Rohdaten der Schichten 0 und 1 aller Spulen Ch0 - ChN gewichtet werden, um die der Schicht 1 zugeordneten Rohdaten der Spulen Ch0 - ChN zu gewinnen. Weiterhin ist in FIG 2 auch ein Faltungskern K_{0,0} gezeigt, der aus den gemischten Rohdaten der Schichten 0 und 1 der Spulen Ch0 - ChN die Rohdaten der Schicht 0 extrahiert.

Um einen Datenpunkt in der Rohdatenschicht S0 des Spulenelementes Ch0 zu berechnen, werden die gemessenen Rohdaten der simultan gemessenen Schichten S0+S1 aller Spulenelemente Ch0 bis ChN mit den jeweils zugehörigen Kerneln K_{n,0} gewichtet. Die Berechnung eines Datenpunktes erfordert den Einsatz von N spezifischen Kerneln, wenn N die Anzahl der Spulenelemente wiedergibt. Somit existiert zur Trennung der simultan gemessenen Rohdaten insgesamt eine Anzahl von verschiedenen Kerneln, die sich aus dem Produkt des Quadrats der Anzahl N der Spulenelemente, des SMS-Faktors (Beschleunigungsfaktor) und der Anzahl der Anregungen ergibt.

Die Berechnung eines einzelnen Punktes P im getrennten Rohdatensignal Ch0, S0 iteriert über alle (noch ungetrennten) Daten Ch0, S0+1 bis ChN, S0+1 und auf den Punkt P jedes noch ungetrennten Datensatzes n (also Chn, S0+1) wird der zu dieser Spule, zu dieser Anregung S0+1, für diese getrennte Zielschicht S0 passende Kernel angewandt. Das Ergebnis dieser Anwendungen wird aufsummiert und ergibt den Wert an Punkt P im getrennten Rohdatensignal Ch0, S0.

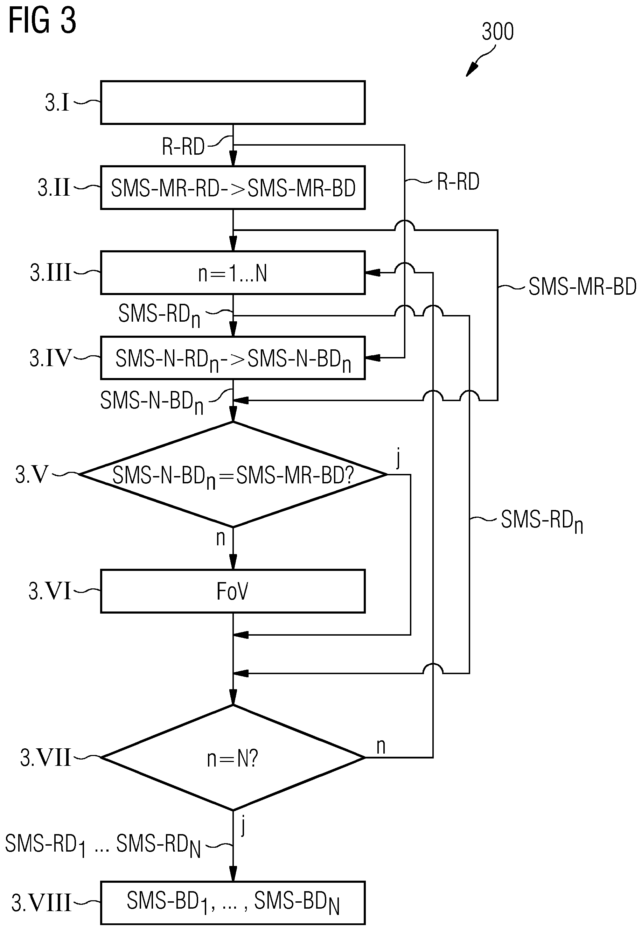

In FIG 3 ist ein Flussdiagramm 300 gezeigt, welches ein Magnetresonanzbildgebungsverfahren zur Erzeugung einer Mehrzahl von Bilddatensätzen eines Bildaufnahmebereichs FoV eines Untersuchungsobjekts mit unterschiedlich gewählten Bildgebungsparametern gemäß einem Ausführungsbeispiel der Erfindung veranschaulicht. Bei dem Schritt 3.I werden zunächst Magnetresonanz-Referenz-Rohdaten R-RD von dem Bildaufnahmebereich FoV aufgenommen. Die Magnetresonanz-Referenz-Rohdaten R-RD werden im Gegensatz zu den Rohdaten SMS-RDₙ der nachfolgenden eigentlichen Bildaufnahmen sequentiell aufgenommen, d.h. einzelne Schichten werden nacheinander und nicht simultan aufgenommen. Auf Basis dieser Einzelschichtaufnahme bzw. der daraus gewonnenen Magnetresonanz-Referenz-Rohdaten R-RD werden nun, wie in FIG 1 und FIG 2 veranschaulicht, Faltungskerne berechnet, die zur Trennung von bei den folgenden Mehrschichtaufnahmen simultan aufgenommenen MagnetresonanzRohdaten SMS-RD sowie von zwischen den Mehrschichtaufnahmen durchgeführten beschleunigten Navigator-Aufnahmen genutzt werden.

Bei dem Schritt 3.II wird nun zusätzlich eine simultane Magnetresonanz-Bildaufnahme von dem Untersuchungsbereich FoV durchgeführt, wobei Magnetresonanz-Bewegungs-ReferenzRohdaten SMS-MR-RD simultan aufgenommen werden. Diese Magnetresonanz-Bewegungs-Referenz-Rohdaten SMS-MR-RD dienen der Bewegungskorrektur später simultan aufgenommener Magnetresonanz-Rohdaten SMS-RDₙ. Die einzelnen Schichten der simultan aufgenommenen Magnetresonanz-Bewegungs-Referenz-Rohdaten SMS-MR-RD lassen sich mit Hilfe der bei dem Schritt 3.1 aufgenommenen Magnetresonanz-Referenzrohdaten R-RD voneinander trennen. Auf Basis der Magnetresonanz-Bewegungs-Referenz-Rohdaten SMS-MR-RD werden weiterhin Magnetresonanz-Bewegungs-Referenz-Bilddaten SMS-MR-BD rekonstruiert, die später als Vergleichsbilder zur Bewegungskorrektur der eigentlichen Bildaufnahmen genutzt werden können.

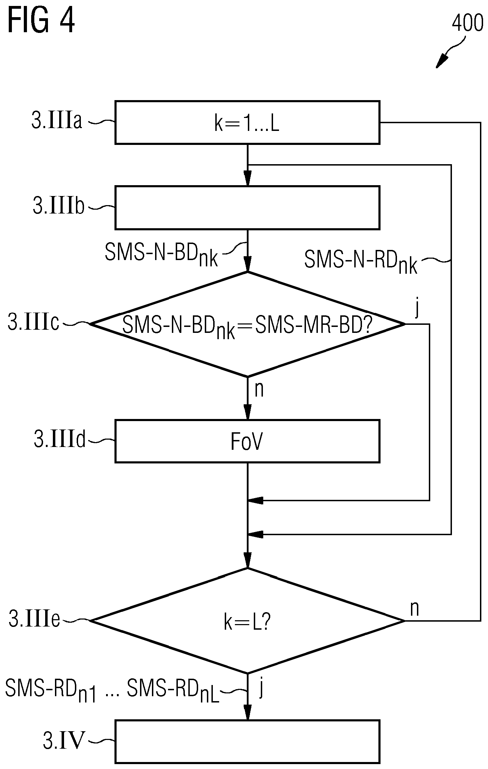

Bei dem Schritt 3.III wird nun eine erste von insgesamt N (N ist eine natürliche Zahl) simultanen Bildaufnahmen von dem Untersuchungsbereich FoV zu Bilddarstellungszwecken durchgeführt. Dabei werden simultan aufgenommene Rohdaten SMS-RDₙ von dem Untersuchungsbereich FoV erfasst. Details der einzelnen Bildaufnahmen sind in FIG 4 veranschaulicht, wobei Teilschritte 3.IIIa bis 3.IIIf des Schritts 3.III gezeigt sind.

Bei dem Schritt 3.IV wird nun eine simultane Navigator-MR-Bildaufnahme durchgeführt, wobei simultane Navigator-Rohdaten SMS-N-RDₙ erzeugt werden. Auf Basis der simultanen Navigator-Rohdaten SMS-N-RDₙ werden anschließend simultane NavigatorBilddaten SMS-N-BDₙ rekonstruiert.

Bei dem Schritt 3.V erfolgt dann ein Vergleich der auf Basis der Navigator-Rohdaten SMS-N-RDₙ rekonstruierten NavigatorBilddaten SMS-N-BDₙ mit Bewegungsreferenz-Bilddaten SMS-MR-BD, welche auf Basis der bei dem Schritt 3.II aufgenommenen Magnetresonanz-Bewegungsreferenz-Rohdaten SMS-MR-RD rekonstruiert wurden. Für den Fall, dass die beiden verglichenen Bilddatensätze keine unterschiedlichen Bildbereiche zeigen, was in FIG 3 mit "j" gekennzeichnet ist, wird zu dem Schritt 3.VII übergegangen. Für den Fall, dass bei dem Schritt 3.IV ermittelt wird, dass sich der Bildbereich der NavigatorBilddaten SMS-N-BDₙ gegenüber dem Bildbereich der Bewegungsreferenz-Bilddaten SMS-MR-BD verschoben haben, was in FIG 3 mit "n" gekennzeichnet ist, wird zu dem Schritt 3.VI übergegangen.

Bei dem Schritt 3.VI erfolgt dann eine Korrektur des Sichtfeldes FoV, um die Verschiebung des Aufnahmebereichs zu kompensieren. Für den Fall, dass alle N Bildaufnahmen durchgeführt wurden, was bei dem Schritt 3.VII geprüft wird und in FIG 3 mit "j" gekennzeichnet ist, wird zu dem Schritt 3.VIII übergegangen. Falls noch nicht alle N Bilder aufgenommen wurden, was in FIG 3 mit "n" gekennzeichnet ist, wird zu dem Schritt 3.III zurückgekehrt und es werden die Schritte 3.III bis 3.VI erneut durchlaufen. Die Schritte 3.III bis 3.VI werden insgesamt (N-1)-mal wiederholt, bis alle N Bildaufnahmen durchgeführt wurden.

Schließlich werden bei dem Schritt 3.VIII auf Basis der simultan erfassten N Magnetresonanz-Rohdaten SMS-RDₙ (n= 1 bis N) N Sätze von Magnetresonanz-Bilddaten SMS-BDₙ (n = 1 bis N) rekonstruiert, welche dann anschließend auf einer Bildanzeige dargestellt werden können.

In FIG 4 ist ein Flussdiagramm gezeigt, welches den in FIG 3 skizzierten Schritt 3.III in einer besonderen Ausgestaltung im Detail veranschaulicht. Die Aufnahme der Magnetresonanzrohdaten SMS-RDₙ von dem Untersuchungsbereich FoV wird dabei in L Teilaufnahmen unterteilt, zwischen denen jeweils noch im Rahmen einer simultanen Navigator-Aufnahme Navigator-Rohdaten SMS-N-RDₙₖ erfasst werden (k = 1 ... L-1, L ist einen natürliche Zahl). Bei dem Schritt 3.IIIa werden zunächst erste Magnetresonanz-Rohdaten SMS-RDₙ₁ erfasst.

Nachfolgend erfolgt bei dem Schritt 3.IIIb eine erste, innerhalb einer Bildaufnahme vorgenommene Navigator-Bildaufnahme, wobei mit Hilfe eines simultanen MR-Bildgebungsverfahrens Navigator-Rohdaten SMS-N-RDₙ₁ erfasst werden und auf Basis der Navigator-Rohdaten SMS-N-RDₙ₁ entsprechende Bilddaten SMS-N-BDₙ₁ rekonstruiert werden.

Bei dem Schritt 3.IIIc wird dann ein Vergleich zwischen den Navigator-Bilddaten SMS-N-BDₙ₁ und dem entsprechenden Teil der bei dem Schritt 3.II (siehe FIG 3) rekonstruierten Magnetresonanz-Bewegungs-Referenz-Bilddaten SMS-MR-BD durchgeführt. Für den Fall, dass die beiden verglichenen Bilddatensätze keine unterschiedlichen Bildbereiche zeigen, was in FIG 4 mit "j" gekennzeichnet ist, wird zu dem Schritt 3.IIIe übergegangen. Für den Fall, dass bei dem Schritt 3.IIIc ermittelt wird, dass sich der Bildbereich der Navigator-Bilddaten SMS-N-BDₙ₁ gegenüber dem entsprechenden Bildbereich der Bewegungsreferenz-Bilddaten SMS-MR-BD verschoben hat, was in FIG 3 mit "n" gekennzeichnet ist, wird zu dem Schritt 3.IIId übergegangen.

Bei dem Schritt 3.IIId erfolgt nun eine Korrektur des Sichtfeldes FoV, um die Verschiebung des Aufnahmebereichs zu kompensieren. Für den Fall, dass alle L Teil-Bildaufnahmen durchgeführt wurden, was bei dem Schritt 3.IIIe geprüft wird, und in FIG 4 mit "j" gekennzeichnet ist, wird zu dem Schritt 3.IV übergegangen. Falls noch nicht alle L Teil-Bilder aufgenommen wurden, was in FIG 4 mit "n" gekennzeichnet ist, wird zu dem Schritt 3.IIIa zurückgekehrt und es werden die Schritte 3.IIIa bis 3.IIIe erneut durchlaufen. Die Schritte 3.IIIa bis 3.IIIe werden insgesamt (L-1)-mal wiederholt, bis alle L Teil-Bildaufnahmen SMS-N-BDₙ₁ ... SMS-N-BD_{nL} durchgeführt wurden. Schließlich wird zu dem Schritt 3.IV übergegangen.

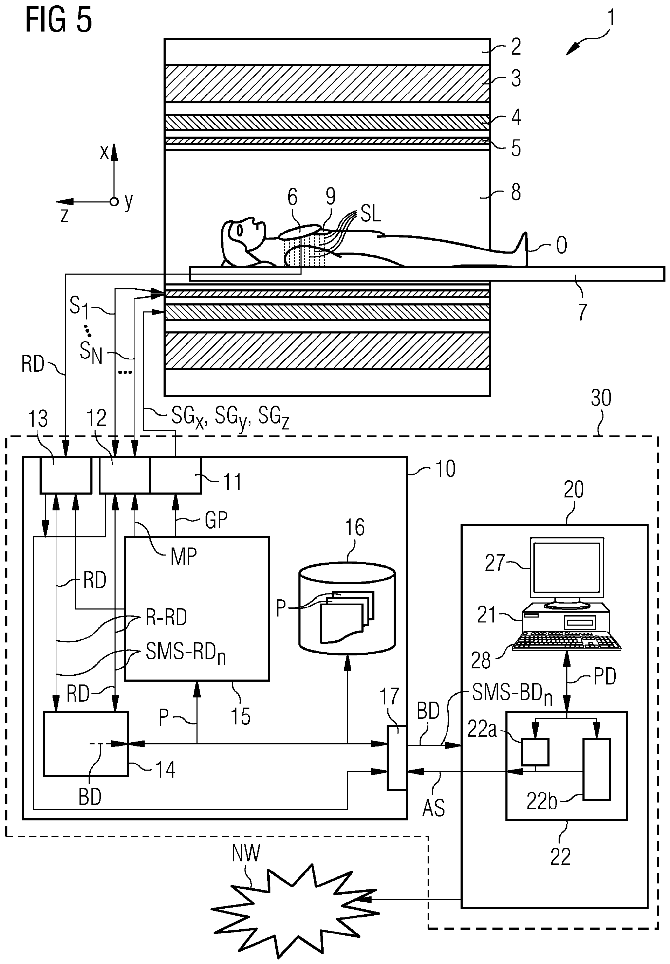

FIG 5 zeigt grob schematisch eine erfindungsgemäße Magnetresonanzanlage bzw. ein Magnetresonanzbildgebungssystem 1. Es umfasst den eigentlichen Magnetresonanzscanner 2 mit einem darin befindlichen Messraum 8 bzw. Patiententunnel. Eine Liege 7 ist in diesen Patiententunnel 8 hineinfahrbar, so dass ein darauf liegendes Untersuchungsobjekt O (beispielsweise ein Patient/Proband oder ein zu untersuchendes Material) während einer Untersuchung an einer bestimmten Position innerhalb des Magnetresonanzscanners 2 relativ zu dem darin angeordneten Magnetsystem und Hochfrequenzsystem gelagert werden kann bzw. auch während einer Messung zwischen verschiedenen Positionen verfahrbar ist.

Wesentliche Komponenten des Magnetresonanzscanners 2 sind ein Grundfeldmagnet 3, ein Gradientensystem 4 mit Gradientenspulen, um beliebige Magnetfeldgradienten in x-, y- und z- Richtung anzulegen, sowie eine Ganzkörper-Hochfrequenzspule 5. Alternativ oder zusätzlich können auch lokale Sendespulen zur Anregung von Magnetresonanzsignalen eingesetzt werden, wie es zum Beispiel bei der Kniebildgebung der Fall ist.

Der Empfang von im Untersuchungsobjekt O induzierten Magnetresonanzsignalen kann über die Ganzkörperspule 5 erfolgen, mit der in der Regel auch die Hochfrequenzsignale zur Induzierung der Magnetresonanzsignale ausgesendet werden. Üblicherweise werden diese Signale aber mit beispielsweise auf oder unter das Untersuchungsobjekt O gelegten Lokalspulen 6 empfangen. Alle diese Komponenten sind dem Fachmann grundsätzlich bekannt und daher in FIG 5 nur grob schematisch dargestellt.

Die Ganzkörper-Hochfrequenzspule 5 kann z. B. in Form einer so genannten Birdcage-Antenne eine Anzahl N von einzelnen Antennenstäben aufweisen, die als einzelne Sendekanäle S1, ..., SN separat von einer Steuereinrichtung 10 ansteuerbar sind, d. h. es handelt sich bei dem Magnetresonanztomographiesystem 1 um ein pTX-fähiges System. Es wird aber ausdrücklich darauf hingewiesen, dass das erfindungsgemäße Verfahren auch an klassischen Magnetresonanztomographiegeräten mit nur einem Sendekanal anwendbar ist.

Weiterhin umfasst die Magnetresonanzanlage 1 eine Steuerungseinrichtung 30 gemäß einem Ausführungsbeispiel der Erfindung. Die Steuerungseinrichtung 30 umfasst die bereits genannte Steuereinrichtung 10 sowie ein Terminal 20. Bei der Steuereinrichtung 10 kann es sich um einen Steuerrechner handeln, der auch aus einer Vielzahl von - gegebenenfalls auch räumlich getrennten und über geeignete Bussysteme bzw. Kabel oder dergleichen untereinander verbundenen - Einzelrechnern bestehen kann. Über eine Terminalschnittstelle 17 ist diese Steuereinrichtung 10 mit dem bereits genannten Terminal 20 verbunden, über das ein Bediener die gesamte Anlage 1 ansteuern kann. Im vorliegenden Fall weist dieses Terminal 20 einen Rechner 21 mit Tastatur 28, einem oder mehreren Bildschirmen 27 sowie weiteren Eingabegeräten wie beispielsweise Maus oder dergleichen auf, so dass dem Bediener eine grafische Benutzeroberfläche zur Verfügung steht. Weiterhin weist das Terminal 20 zusätzliche Einheiten 22, 22a, 22b auf, die zur Ausführung des erfindungsgemäßen Verfahrens genutzt werden.

Die Steuereinrichtung 10 weist u. a. eine Gradienten-Steuereinheit 11 auf, die wiederum aus mehreren Teilkomponenten bestehen kann. Über diese Gradienten-Steuereinheit 11 werden die einzelnen Gradientenspulen mit Steuersignalen SGx, SGy, SGz beschaltet. Hierbei handelt es sich um Gradientenpulse, die während einer Messung an genau vorgesehenen zeitlichen Positionen und mit einem genau vorgegebenen zeitlichen Verlauf gesetzt werden, um das Untersuchungsobjekt O und den zugeordneten k-Raum vorzugsweise in einzelnen Schichten SL gemäß einer Ansteuersequenz AS abzutasten.

Die Steuereinrichtung 10 weist außerdem eine Hochfrequenz-Sende-/Empfangseinheit 12 auf. Diese HF-Sende-/Empfangseinheit 12 besteht ebenfalls aus mehreren Teilkomponenten, um jeweils separat und parallel auf die einzelnen Sendekanäle S1, ... SN, d. h. in diesem Fall auf die einzeln ansteuerbaren Antennenstäbe der Ganzkörperspule 5, Hochfrequenzpulse aufzugeben. Über die Sende-/Empfangseinheit 12 können auch Magnetresonanzsignale empfangen werden. In diesem Ausführungsbeispiel geschieht dies aber mit Hilfe der Lokalspulen 6. Die mit diesen Lokalspulen 6 empfangenen Rohdaten RD werden von einer HF-Empfangseinheit 13 ausgelesen und verarbeitet. Die hiervon oder von der Ganzkörperspule 5 mittels der HF-Sende-/Empfangseinheit 12 empfangenen Magnetresonanzsignale werden als Rohdaten RD an eine Rekonstruktionseinheit 14 übergeben, die daraus die Bilddaten BD rekonstruiert und diese in einem Speicher 16 hinterlegt und/oder über die Schnittstelle 17 an das Terminal 20 übergibt, so dass der Bediener sie betrachten kann. Die Bilddaten BD können auch über ein Netzwerk NW an anderen Stellen gespeichert und/oder angezeigt und ausgewertet werden. Sofern die Lokalspulen 6 eine geeignete Umschalteinheit aufweisen, können auch diese an eine HF-Sende-/Empfangseinheit 12 angeschlossen sein, um die Lokalspulen auch zum Senden insbesondere im pTX-Betrieb zu verwenden.

Die Gradientensteuerung 11, die HF-Sende-/Empfangseinheit 12 und die Empfangseinheit 13 für die Lokalspulen 6 werden jeweils koordiniert durch eine Messsteuereinheit 15 angesteuert. Diese sorgt durch entsprechende Befehle dafür, dass ein gewünschter Gradienten-Pulszug GP durch geeignete Gradientensteuersignale SGx, SGy, SGz ausgesendet wird, und steuert parallel die HF-Sende-/Empfangseinheit 12 so an, dass ein Mehrkanal-Pulszug MP ausgesendet wird, d. h. dass auf den einzelnen Sendekanälen S1, ... SN parallel die passenden Hochfrequenzpulse auf die einzelnen Sendestäbe der Ganzkörperspule 5 gegeben werden. Außerdem muss dafür gesorgt werden, dass zum passenden Zeitpunkt die Magnetresonanzsignale an den Lokalspulen 6 durch die HF-Empfangseinheit 13 bzw. eventuelle Signale an der Ganzkörperspule 5 durch die HF-Sende-/Empfangseinheit 12 ausgelesen und weiterverarbeitet werden. Die Messsteuereinheit 15 gibt die entsprechenden Signale, insbesondere den Mehrkanal-Pulszug MP an die Hochfrequenz-Sende-/Empfangseinheit 12 und den Gradienten-Pulszug GP an die Gradienten-Steuereinheit 11, gemäß einem vorgegebenen Steuerprotokoll P vor. In diesem Steuerprotokoll P sind alle Steuerdaten hinterlegt, die während einer Messung gemäß einer vorgegebenen Ansteuersequenz AS eingestellt werden müssen.

Üblicherweise sind in einem Speicher 16 eine Vielzahl von Steuerprotokollen P für verschiedene Messungen hinterlegt. Diese können über das Terminal 20 vom Bediener ausgewählt und gegebenenfalls variiert werden, um dann ein passendes Steuerprotokoll P für die aktuell gewünschte Messung zur Verfügung zu haben, mit dem die Messsteuereinheit 15 arbeiten kann. Im Übrigen kann der Bediener auch über ein Netzwerk NW Steuerprotokolle P, beispielsweise von einem Hersteller des Magnetresonanzsystems, abrufen und diese dann gegebenenfalls modifizieren und nutzen.

Der grundlegende Ablauf einer solchen Magnetresonanzmessung und die genannten Komponenten zur Ansteuerung sind dem Fachmann aber bekannt, so dass sie hier im Detail nicht weiter besprochen werden. Im Übrigen kann ein solcher Magnetresonanzscanner 2 sowie die zugehörige Steuereinrichtung 10 noch eine Vielzahl weiterer Komponenten aufweisen, die hier ebenfalls nicht im Detail erläutert werden. Es wird an dieser Stelle darauf hingewiesen, dass der Magnetresonanzscanner 2 auch anders aufgebaut sein kann, beispielsweise mit einem seitlich offenen Patientenraum, und dass im Prinzip die Hochfrequenz-Ganzkörperspule nicht als Birdcage-Antenne aufgebaut sein muss.

Die in FIG 5 gezeigte Messsteuereinheit, auch als Ansteuereinheit 15 bezeichnet, ist dazu eingerichtet die Scaneinheit 2 des Magnetresonanzbildgebungssystems 1 mit einer Bildaufnahmesequenz zur Erzeugung einer Mehrzahl von Bilddatensätzen BD eines Bildaufnahmebereichs FoV eines Untersuchungsobjekts O mit unterschiedlich gewählten Bildgebungsparametern anzusteuern.

Die genannte Bildaufnahmesequenz AS wird von einer Sequenzerzeugungseinheit 22 erzeugt, die in dem in FIG 5 gezeigten Beispiel Teil des Terminals 20 sind. Die Sequenzerzeugungseinheit 22 erhält Protokolldaten PD von dem Rechner 21. Teil der Sequenzerzeugungseinheit 22 ist eine Referenzsequenz-Erzeugungseinheit 22a zum Erzeugen einer Referenz-Bildaufnahme-Teilsequenz zum Erfassen eines Satzes R-RD von Referenz-Magnetresonanzrohdaten von einem Bildaufnahmebereich FoV. Zudem umfasst die Sequenzerzeugungseinheit 22 auch eine Bildsequenz-Erzeugungseinheit 22b zum Erzeugen einer Mehrzahl von Bildaufnahme-Teilsequenzen zum zeitlich nacheinander Erfassen von Magnetresonanz-Rohdatensätzen SMS-RDₙ mit unterschiedlichen Bildgebungsparametern, wobei die Bildaufnahme-Teilsequenzen jeweils eine SMS-Bildaufnahmesequenz umfassen.

Die bereits erwähnte Rekonstruktionseinheit 14, welche in dem in FIG 5 gezeigten Ausführungsbeispiel Teil der Steuereinrichtung 10 ist, dient dazu, eine Mehrzahl von Bilddatensätzen SMS-BDₙ auf Basis der erfassten Magnetresonanz-Rohdatensätze SMS-RDₙ zu rekonstruieren, wobei eine Mehrzahl von SMS-Bilddatensätzen SMS-BDₙ jeweils auf Basis eines der mit einer SMS-Bildaufnahmesequenz aufgenommenen Magnetresonanz-Rohdatensätze SMS-RDₙ und jeweils auf Basis ein und desselben Satzes von Referenz-Magnetresonanzrohdaten R-RD rekonstruiert werden.

Die beschriebenen Einheiten 15, 22a, 22b, 14 der Steuerungseinrichtung 30 zur Steuerung der Bildgebung können dabei, wie dargestellt in dem Magnetresonanzsystem 1 umfasst sein und insbesondere auch Bestandteil der Steuereinrichtung 10 sein. Jedoch ist auch denkbar, dass die genannten Einheiten extern als eigenständige Baueinheit vorliegen und zur Nutzung mit mehreren unterschiedlichen Magnetresonanzsystemen ausgebildet sind.

Es wird abschließend noch einmal darauf hingewiesen, dass es sich bei den zuvor beschriebenen detaillierten Verfahren und Aufbauten um Ausführungsbeispiele handelt und dass das Grundprinzip auch in weiten Bereichen vom Fachmann variiert werden kann, ohne den Bereich der Erfindung zu verlassen, soweit er durch die Ansprüche vorgegeben ist. Es wird der Vollständigkeit halber auch darauf hingewiesen, dass die Verwendung der unbestimmten Artikel "ein" bzw. "eine" nicht ausschließt, dass die betreffenden Merkmale auch mehrfach vorhanden sein können. Ebenso schließt der Begriff "Einheit" nicht aus, dass diese aus mehreren Komponenten besteht, die gegebenenfalls auch räumlich verteilt sein können.

## Patentansprüche

1. Magnetresonanzbildgebungsverfahren zur Erzeugung einer Mehrzahl von Bilddatensätzen (BD) eines Bildaufnahmebereichs (FoV) eines Untersuchungsobjekts (O), wobei
- mindestens ein Satz (R-RD) von Referenz-Magnetresonanzrohdaten von dem Bildaufnahmebereich (FoV) erfasst wird,
- eine Mehrzahl von Magnetresonanz-Rohdatensätzen (RD) zeitlich nacheinander erfasst werden, wobei zumindest eine Mehrzahl (SMS-RDₙ) der Magnetresonanz-Rohdatensätze (RD) mit einer SMS-Bildaufnahmesequenz aufgenommen werden,
- eine Rekonstruktion einer Mehrzahl von Bilddatensätzen (BD) auf Basis der erfassten Magnetresonanz-Rohdatensätze (RD) erfolgt, wobei eine Mehrzahl von SMS-Bilddatensätzen (SMS-BDₙ) jeweils auf Basis eines der mit einer SMS-Bildaufnahmesequenz aufgenommenen Magnetresonanz-Rohdatensätze (SMS-RDₙ) und jeweils auf Basis ein und desselben Satzes (R-RD) von Referenz-Magnetresonanzrohdaten rekonstruiert werden,
**dadurch gekennzeichnet, dass**
die Bilddatensätze (BD) zur Bilddarstellung des Bildaufnahmebereichs verwendete Bilddatensätze (SMS-BDₙ) und Navigatorbilddatensätze (SMS-N-BDₙ)umfassen, und dass Magnetresonanz-Rohdatensätze (SMS-N-RDₙ) zur Rekonstruktion von Navigatorbilddatensätzen (SMS-N-BDₙ) zwischen der Aufnahme von Magnetresonanz-Rohdatensätzen (SMS-RDₙ), welche zur Rekonstruktion einer Bilddarstellung des Bildaufnahmebereichs (FoV) genutzt werden, erfasst werden.

2. Verfahren nach Anspruch 1, wobei die Mehrzahl von Magnetresonanz-Rohdatensätzen (RD) mit unterschiedlich gewählten Bildgebungsparametern zeitlich nacheinander erfasst werden.

3. Verfahren nach Anspruch 1 oder 2, wobei genau ein Satz (R-RD) von Referenz-Magnetresonanzrohdaten von dem Bildaufnahmebereich (FoV) erfasst wird und alle SMS-Bilddatensätze (SMS-BDₙ) jeweils auf Basis eines der mit einer SMS-Bildaufnahmesequenz aufgenommenen Magnetresonanz-Rohdatensätze (SMS-RDₙ) und jeweils auf Basis des gemeinsamen Satzes (R-RD) von Referenz-Magnetresonanzrohdaten rekonstruiert werden.

4. Verfahren nach einem der Ansprüche 1 bis 3, wobei ein Magnetresonanz-Rohdatensatz (SMS-MR-RD) zur Rekonstruktion eines Referenz-Navigatorbilddatensatzes (SMS-MR-BD) erfasst wird, wobei der Referenz-Navigatorbilddatensatz (SMS-MR-BD) als Bezugsbild für eine Bewegungskorrektur auf Basis der Navigatorbilddatensätze (SMS-N-BDₙ) verwendet wird.

5. Verfahren nach einem der Ansprüche 1 bis 4, wobei mindestens ein Magnetresonanz-Rohdatensatz (SMS-N-RDₙ) zur Rekonstruktion von Navigatorbilddatensätzen (SMS-N-BDₙ) während mindestens einer kurzen Unterbrechung einer Aufnahme von Magnetresonanz-Rohdatensätzen (SMS-RDₙ), welche zur Rekonstruktion einer Bilddarstellung des Bildaufnahmebereichs (FoV) genutzt werden, erfasst wird.

6. Verfahren nach einem der Ansprüche 1 bis 5, wobei eine Mehrzahl (SMS-RDₙ) der Magnetresonanz-Rohdatensätze, welche zur Rekonstruktion einer Bilddarstellung des Bildaufnahmebereichs (FoV) genutzt werden, mit einer SMS-Bildaufnahmesequenz erfasst werden und die SMS-Bilddatensätze (SMS-BDₙ) jeweils auf einem der Mehrzahl der Magnetresonanz-Rohdatensätze (SMS-RDₙ) und jeweils auf Basis ein und desselben Satzes (R-RD) von Referenz-Magnetresonanzrohdaten rekonstruiert werden.

7. Verfahren nach einem der Ansprüche 1 bis 6, wobei zumindest eine Mehrzahl der Magnetresonanz-Rohdatensätze (SMS-RDₙ) zur Rekonstruktion von Navigatorbilddatensätzen (SMS-N-BDₙ) mit einer SMS-Bildaufnahmesequenz erfasst werden und die SMS-Navigatorbilddatensätze (SMS-N-BDₙ) jeweils auf einem der Mehrzahl der Magnetresonanz-Rohdatensätze (SMS-N-RDₙ) und jeweils auf Basis ein und desselben Satzes (R-RD) von Referenz-Magnetresonanzrohdaten rekonstruiert werden.

8. Verfahren nach Anspruch 6 und 7, wobei zumindest ein Teil der SMS-Navigatorbilddatensätze (SMS-N-BDₙ) und ein Teil der SMS-Bilddatensätze (SMS-BDₙ) auf Basis eines gemeinsamen Satzes (R-RD) von Referenz-Magnetresonanzrohdaten rekonstruiert werden.

9. Verfahren nach einem der Ansprüche 2 bis 8, wobei die unterschiedlich gewählten Bildgebungsparameter mindestens eine der folgenden Größen umfassen:
- Amplitudenwert,
- Amplitudenverlauf,
- Startzeitpunkt und Dauer,
- Anzahl der Anregungspulse,
- Sequenztyp,
- Schichtdicke,
- Schichtorientierung.

10. Steuerungseinrichtung (30), aufweisend:
- eine Ansteuerungseinheit (15) eingerichtet zur Ansteuerung einer Scaneinheit (2) eines Magnetresonanzbildgebungssystems (1) mit einer Bildaufnahmesequenz zur Erzeugung einer Mehrzahl von Bilddatensätzen (BD) eines Bildaufnahmebereichs (FoV) eines Untersuchungsobjekts (O),
- eine Referenzsequenz-Erzeugungseinheit (22a) eingerichtet zum Erzeugen einer Referenz-Bildaufnahme-Teilsequenz zum Erfassen mindestens eines Satzes (R-RD) von Referenz-Magnetresonanzrohdaten von dem Bildaufnahmebereich (FoV),
- eine Bildsequenz-Erzeugungseinheit (22b) eingerichtet zum Erzeugen einer Mehrzahl von Bildaufnahme-Teilsequenzen zum zeitlich nacheinander Erfassen von Magnetresonanz-Rohdatensätzen (SMS-RDₙ, SMS-N-RDₙ), wobei zumindest eine Mehrzahl der Bildaufnahme-Teilsequenzen eine SMS-Bildaufnahmesequenz umfassen, und
- eine Rekonstruktionseinheit (14) eingerichtet zum Rekonstruieren einer Mehrzahl von Bilddatensätzen (BD, SMS-BDₙ, SMS-N-BDₙ) auf Basis der erfassten Magnetresonanz-Rohdatensätze (SMS-RDₙ, SMS-N-RDₙ), wobei eine Mehrzahl von SMS-Bilddatensätzen (SMS-BDₙ) jeweils auf Basis eines der mit einer SMS-Bildaufnahmesequenz aufgenommenen Magnetresonanz-Rohdatensätze (SMS-RDₙ) und jeweils auf Basis ein und desselben Satzes von Referenz-Magnetresonanzrohdaten (R-RD) rekonstruiert werden,
**dadurch gekennzeichnet, dass** die Bilddatensätze (BD) zur Bilddarstellung des Bildaufnahmebereichs verwendete Bilddatensätze (SMS-BDn) und Navigatorbilddatensätze (SMS-N-BDn) umfassen, und dass Magnetresonanz-Rohdatensätze (SMS-N-RDₙ) zur Rekonstruktion von Navigatorbilddatensätzen (SMS-N-BDₙ) zwischen der Aufnahme von Magnetresonanz-Rohdatensätzen (SMS-RDₙ), welche zur Rekonstruktion einer Bilddarstellung des Bildaufnahmebereichs (FoV) genutzt werden, erfasst werden.

11. Magnetresonanzbildgebungssystem (1), umfassend:
- eine Scaneinheit (2) und
- eine Steuerungseinrichtung (30) nach Anspruch 10.

12. Computerprogrammprodukt mit einem Computerprogramm, welches direkt in eine Speichereinrichtung einer Steuereinrichtung (10, 20, 30) eines Magnetresonanzbildgebungssystems (1) ladbar ist, mit Programmabschnitten, um alle Schritte des Verfahrens nach einem der Ansprüche 1 bis 9 auszuführen, wenn das Computerprogramm in der Steuereinrichtung des Magnetresonanzbildgebungssystems ausgeführt wird.

13. Computerlesbares Medium, auf welchem von einer Rechnereinheit eines Magnetresonanzbildgebungssystems einlesbare und ausführbare Programmabschnitte gespeichert sind, um alle Schritte des Verfahrens nach einem der Ansprüche 1 bis 9 auszuführen, wenn die Programmabschnitte von der Rechnereinheit ausgeführt werden.

## Claims

1. Magnetic resonance imaging method for generating a plurality of image data sets (BD) of an image recording region (FoV) of an examination object (O), wherein
- at least one set (R-RD) of reference magnetic resonance raw data is captured from the image recording region (FoV),
- a plurality of magnetic resonance raw data sets (RD) are captured temporally sequentially, wherein at least a plurality (SMS-RDₙ) of the magnetic resonance raw data sets (RD) are recorded with an SMS image recording sequence,
- a reconstruction of a plurality of image data sets (BD) takes place on the basis of the captured magnetic resonance raw data sets (RD), wherein a plurality of SMS image data sets (SMS-BDₙ) are each reconstructed on the basis of one of the magnetic resonance raw data sets (SMS-RDₙ) recorded with an SMS image recording sequence and each on the basis of one and the same set (R-RD) of reference magnetic resonance raw data,
**characterised in that**
the image data sets (BD) comprise image data sets (SMS-BDₙ) and navigator image data sets (SMS-N-BDₙ) for image display of the image recording region, and
magnetic resonance raw data sets (SMS-N-RDₙ) are captured for reconstruction of navigator image data sets (SMS-N-BDₙ) between the recording of magnetic resonance raw data sets (SMS-RDₙ) which are used for the reconstruction of an image display of the image recording region (FoV).

2. Method according to claim 1, wherein the plurality of magnetic resonance raw data sets (RD) are captured temporally sequentially with differently selected imaging parameters.

3. Method according to claim 1 or 2, wherein exactly one set (R-RD) of reference magnetic resonance raw data is captured from the image recording region (FoV) and all SMS image data sets (SMS-BDₙ) are each reconstructed on the basis of one of the magnetic resonance raw data sets (SMS-RDₙ) recorded with an SMS image recording sequence and each on the basis of the common set (R-RD) of reference magnetic resonance raw data.

4. Method according to one of claims 1 to 3, wherein a magnetic resonance raw data set (SMS-MR-RD) is captured for reconstruction of a reference navigator image data set (SMS-MR-BD), wherein the reference navigator image data set (SMS-MR-BD) is used as a reference image for a movement correction on the basis of the navigator image data sets (SMS-N-BDₙ).

5. Method according to one of claims 1 to 4, wherein at least one magnetic resonance raw data set (SMS-N-RDₙ) is captured for reconstruction of navigator image data sets (SMS-N-BDₙ) during at least one short interruption of a recording of magnetic resonance raw data sets (SMS-RDₙ) which are used for the reconstruction of an image display of the image recording region (FoV).

6. Method according to one of claims 1 to 5, wherein a plurality (SMS-RDₙ) of the magnetic resonance raw data sets which are used for the reconstruction of an image display of the image recording region (FoV) are captured with an SMS image recording sequence and the SMS image data sets (SMS-BDₙ) are each reconstructed on one of the plurality of the magnetic resonance raw data sets (SMS-RDₙ) and each on the basis of one and the same set (R-RD) of reference magnetic resonance raw data.

7. Method according to one of claims 1 to 6, wherein at least a plurality of the magnetic resonance raw data sets (SMS-RDₙ) are captured for the reconstruction of navigator image data sets (SMS-N-BDₙ) with an SMS image recording sequence and the SMS navigator image data sets (SMS-N-BDₙ) are each reconstructed on one of the plurality of the magnetic resonance raw data sets (SMS-N-RDₙ) and each on the basis of one and the same set (R-RD) of reference magnetic resonance raw data.

8. Method according to claim 6 and 7, wherein at least a part of the SMS navigator image data sets (SMS-N-BDₙ) and a part of the SMS image data sets (SMS-BDₙ) are reconstructed on the basis of a common set (R-RD) of reference magnetic resonance raw data.

9. Method according to one of claims 2 to 8, wherein the differently selected imaging parameters comprise at least one of the following variables:
- the amplitude value,
- the amplitude variation,
- the start point and duration,
- the number of excitation pulses,
- the sequence type,
- the slice thickness,
- the slice orientation.

10. Control device (30), having:
- an activation unit (15) designed for activating a scan unit (2) of a magnetic resonance imaging system (1) with an image recording sequence for generating a plurality of image data sets (BD) of an image recording region (FoV) of an examination object (O),
- a reference sequence generating unit (22a) designed for generating a reference image recording subsequence for capturing at least one set (R-RD) of reference magnetic resonance raw data from the image recording region (FoV),
- an image sequence generating unit (22b) designed for generating a plurality of image recording subsequences for the temporally sequential acquisition of magnetic resonance raw data sets (SMS-RDₙ, SMS-N-RDₙ), wherein at least a plurality of the image recording subsequences comprise an SMS image recording sequence, and
- a reconstruction unit (14) designed for reconstructing a plurality of image data sets (BD, SMS-BDₙ, SMS-N-BDₙ) on the basis of the captured magnetic resonance raw data sets (SMS-RDₙ, SMS-N-RDₙ), wherein a plurality of SMS image data sets (SMS-BDₙ) are each reconstructed on the basis of one of the magnetic resonance raw data sets (SMS-RDₙ) recorded with an SMS image recording sequence and each on the basis of one and the same set of reference magnetic resonance raw data (R-RD),
**characterised in that** the image data sets (BD) comprise image data sets (SMS-BDₙ) and navigator image data sets (SMS-N-BDₙ) for image display of the image recording region, and
magnetic resonance raw data sets (SMS-N-RDₙ) are captured for reconstruction of navigator image data sets (SMS-N-BDₙ) between the recording of magnetic resonance raw data sets (SMS-RDₙ) which are used for the reconstruction of an image display of the image recording region (FoV).

11. Magnetic resonance imaging system (1), comprising:
- a scanning unit (2) and
- a control device (30) according to claim 10.

12. Computer program product having a computer program which is directly loadable into a storage device of a control system (10, 20, 30) of a magnetic resonance imaging system (1), having program portions in order to carry out all the steps of the method according to one of claims 1 to 9 when the computer program is executed in the control device of the magnetic resonance imaging system.

13. Computer-readable medium on which program portions that can be read in and executed by a computer unit of a magnetic resonance imaging system are stored, in order to carry out all the steps of the method according to one of claims 1 to 9 when the program portions are executed by the computer unit.

## Revendications

1. Procédé d'imagerie par résonnance magnétique de production d'une pluralité d'ensembles (BD) de données d'image d'une région (FoV) de prise d'image d'un objet (O) à examiner, dans lequel
- on saisit au moins un ensemble (R-RD) de données brutes de résonnance magnétique de référence de la région (FoV) de prise d'image,
- on saisit successivement dans le temps une pluralité d'ensembles (RD) de données brutes de résonnance magnétique, dans lequel on prend au moins une pluralité (SMS-RDₙ) des ensembles (RD) de données d'image de résonnance magnétique par une séquence de prise d'image SMS,
- on effectue une reconstruction d'une pluralité d'ensembles (BD) de données d'image sur la base des ensembles (RD) de données brutes de résonnance magnétique saisies, dans lequel on reconstruit une pluralité d'ensembles (SMS-BDₙ) de données d'image SMS respectivement sur la base de l'un des ensembles (SMS-RDₙ) de données brutes de résonnance magnétique pris par une séquence de prise d'image SMS, et respectivement sur la base d'un et du même ensemble (R-RD) de données brutes de résonnance magnétique de référence,
**caractérisé en ce que**
les ensembles (BD) de données d'image comprennent des ensembles (SMS-BDₙ) de données d'image utilisés pour la représentation imagée de la région de prise d'image et des ensembles (SMS-N-BDₙ) de données d'image de navigateur, et **en ce que** on saisit des ensembles (SMS-N-RDₙ) de données brutes de résonnance magnétique pour la reconstruction d'ensembles (SMS-N-BDₙ) de données d'image de navigateur entre la prise d'ensembles (SMS-RDₙ) de données brutes de résonnance magnétique, qui sont utilisés pour la reconstruction d'une représentation imagée de la région (FoV) de prise d'image.

2. Procédé suivant la revendication 1, dans lequel on saisit, successivement dans le temps, la pluralité d'ensembles (RD) de données brutes de résonnance magnétique avec des paramètres d'imagerie choisis différemment.

3. Procédé suivant la revendication 1 ou 2, dans lequel on saisit exactement un ensemble (R-RD) de données brutes de résonnance magnétique de référence de la région (FoV) de prise d'image et on reconstruit tous les ensembles (SMS-BDₙ) de données d'image SMS, respectivement sur la base de l'un des ensembles (SMS-RDₙ) de données brutes de résonnance magnétique enregistrées avec une séquence de prise d'image SMS et respectivement sur la base de l'ensemble (R-RD) commun de données brutes de résonnance magnétique de référence.

4. Procédé suivant l'une des revendications 1 à 3, dans lequel on saisit un ensemble (SMS-MR-RD) de données brutes de résonnance magnétique pour la reconstruction d'un ensemble (SMS-MR-BD) de données d'image de navigateur de référence, dans lequel on utilise l'ensemble (SMS-MR-BD) de données d'image de navigateur de référence comme image de référence pour une correction de mouvement sur la base des ensembles (SMS-N-BDₙ) de données d'image de navigateur.

5. Procédé suivant l'une des revendications 1 à 4, dans lequel on saisit au moins un ensemble (SMS-N-RDₙ) de données brutes de résonnance magnétique pour la reconstruction d'ensembles (SMS-N-BDₙ) de données d'image de navigateur pendant au moins une brève interruption d'un enregistrement d'ensembles (SMS-RDₙ) de données brutes de résonnance magnétique, qui sont utilisés pour la reconstruction d'une représentation imagée de la région (FoV) de prise d'image.

6. Procédé suivant l'une des revendications 1 à 5, dans lequel on saisit, par une séquence de prise d'image SMS, une pluralité des ensembles (SMS-RDₙ) de données brutes de résonnance magnétique, qui sont utilisés pour la reconstruction d'une représentation imagée de la région (FoV) de prise d'image et on reconstruit les ensembles (SMS-BDₙ) de données d'image SMS, respectivement sur l'un de la pluralité des ensembles (SMS-RDₙ) de données brutes de résonnance magnétique, et respectivement sur la base du un ou du même ensemble (R-RD) de données brutes de résonnance magnétique de référence.

7. Procédé suivant l'une des revendications 1 à 6, dans lequel on saisit, par une séquence de prise d'image SMS, une pluralité des ensembles (SMS-RDₙ) de données brutes de résonnance magnétique pour la reconstruction d'ensembles (SMS-N-BDₙ) de données d'image de navigateur et on reconstruit les ensembles (SMS-N-BDₙ) de données d'image de navigateur, respectivement sur l'un de la pluralité des ensembles (SMS-N-RDₙ) de données brutes de résonnance magnétique, et respectivement sur la base du un et du même ensemble (R-RD) de données brutes de résonnance magnétique de référence.

8. Procédé suivant la revendication 6 et la revendication 7, dans lequel on reconstruit au moins une partie des ensembles (SMS-N-BDₙ) de données d'image de navigateur SMS et une partie des ensembles (SMS-BDₙ) de données d'image SMS sur la base d'un ensemble (R-RD) commun de données brutes de résonnance magnétique de référence.

9. Procédé suivant l'une des revendications 2 à 8, dans lequel les paramètres d'imagerie choisis différemment comprennent au moins l'une des grandeurs suivantes :
- valeur d'amplitude,
- courbe d'amplitude,
- instant de début et durée,
- nombre des impulsions d'excitation,
- type de séquence,
- épaisseur de la couche,
- orientation de la couche.

10. Dispositif (30) de commande, comportant :
- une unité (15) de commande conçue pour commander une unité (2) de scan d'un système (1) d'imagerie par résonnance magnétique par une séquence de prise d'image pour la production d'une pluralité d'ensembles (BD) de données d'image d'une région (FoV) de prise d'image d'un objet (O) à examiner,
- une unité (22a) de production de séquence de référence conçue pour la production d'une séquence partielle de prise d'image de référence pour la saisie d'au moins un ensemble (R-RD) de données brutes de résonnance magnétique de référence de la région (FoV) de prise d'image,
- une unité (22b) de production de séquences d'image conçue pour la production d'une pluralité de séquences partielles de prise d'image pour la saisie successive dans le temps d'ensembles (SMS-RDₙ, SMS-N-RDₙ) de données brutes de résonnance magnétique, dans laquelle au moins une pluralité des séquences partielles de prise d'image comprennent une séquence de prise d'image SMS, et
- une unité (14) de reconstruction conçue pour la reconstruction d'une pluralité d'ensembles (BD, SMS-BDₙ, SMS-N-BDₙ) de données d'image sur la base des ensembles (SMS-RDₙ, SMS-N-RDₙ) de données brutes de résonnance magnétique saisis, dans laquelle une pluralité d'ensembles (SMS-BDₙ) de données d'image SMS sont reconstruits respectivement sur la base de l'un des ensembles (SMS-RDₙ) de données brutes de résonnance magnétique enregistré par une séquence de prise d'image SMS, et respectivement sur la base d'un et du même ensemble de données (R-RD) brutes de résonnance magnétique de référence,
**caractérisé en ce que** les ensembles (BD) de données d'image comprennent des ensembles (SMS-BDₙ) de données d'image utilisés pour la représentation imagée de la zone de prise d'image, et des ensembles (SMS-N-BDₙ) de données d'image de navigateur, et **en ce que** des ensembles (SMS-N-RDₙ) de données brutes de résonnance magnétique sont saisis pour la reconstruction d'ensembles (SMS-N-BDₙ) de données d'image de navigateur entre l'enregistrement d'ensembles (SMS-RDₙ) de données brutes de résonnance magnétique, qui sont utilisés pour la reconstruction d'une représentation imagée de la région (FoV) de prise d'image.

11. Système (1) d'imagerie par résonnance magnétique, comprenant :
- une unité (2) de scan et
- un dispositif (30) de commande suivant la revendication 10.

12. Produit de programme d'ordinateur ayant un programme d'ordinateur, qui peut être chargé directement dans un dispositif de mémoire d'un dispositif (10, 20, 30) de commande d'un système (1) d'imagerie par résonnance magnétique, comprenant des parties de programme pour effectuer tous les stades du procédé suivant l'une des revendications 1 à 9, lorsque le programme d'ordinateur est exécuté dans le dispositif de commande du système d'imagerie par résonnance magnétique.

13. Support, déchiffrable par ordinateur, sur lequel sont mémorisées des parties de programme pouvant être lues et réalisées par une unité informatique d'un système d'imagerie par résonnance magnétique pour effectuer tous les stades du procédé suivant l'une des revendications 1 à 9, lorsque les parties de programme sont exécutées par l'unité informatique.
